(19)

Europäisches Patentamt

European Patent Office

Office européen des brevets

(11) **EP 3 311 177 B1**

(12) **EUROPEAN PATENT SPECIFICATION**

(45) Date of publication and mention of the grant of the patent:
**06.05.2020 Bulletin 2020/19**

(21) Application number: **16814838.5**

(22) Date of filing: **05.02.2016**

(51) Int Cl.:
**G01R 15/16** (2006.01)          **G01R 19/25** (2006.01)
**G01R 19/32** (2006.01)

(86) International application number:
**PCT/US2016/016675**

(87) International publication number:
**WO 2016/209322 (29.12.2016 Gazette 2016/52)**

(54) **WEATHER RESISTANT UNGROUNDED POWER LINE SENSOR**

WETTERBESTÄNDIGER UNGEERDETER STROMLEITUNGSSENSOR

CAPTEUR POUR LIGNE D'ÉNERGIE NON MISE À LA TERRE RÉSISTANTE AUX INTEMPÉRIES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.06.2015 US 201514745825**

(43) Date of publication of application:
**25.04.2018 Bulletin 2018/17**

(73) Proprietor: **Foster-Miller, Inc.**
**Waltham, MA 02451 (US)**

(72) Inventors:
• **MEEKER, David C.**
  **Natick, MA 01760 (US)**
• **BERGLUND, Joshua**
  **Hopkinton, MA 01748 (US)**
• **MASON, Timothy J.**
  **Uxbridge, MA 01569 (US)**
• **MURPHREE, Michael L.**
  **Mansfield, MA 02048 (US)**
• **POST, Alexander E.**
  **Watertown, MA 02472 (US)**
• **GODFREY, James F.**
  **Holbrook, MA 02343 (US)**

(74) Representative: **Jones, Graham Henry**
**Graham Jones & Company**
**77 Beaconsfield Road**
**Blackheath, London SE3 7LG (GB)**

(56) References cited:
**WO-A1-2006/021030      JP-A- 2004 257 893**
**US-A- 4 786 862       US-A- 5 252 913**
**US-A1- 2009 153 133    US-A1- 2012 109 556**
**US-A1- 2013 245 401    US-A1- 2014 049 275**
**US-A1- 2014 085 095    US-B1- 6 677 743**
**US-B1- 6 677 743**

**Description**

FIELD OF THE INVENTION

This invention relates to power line sensors and methods.

BACKGROUND OF THE INVENTION

Ungrounded power line sensors measure the voltage of a medium-voltage power line relative to ground through, for example, a capacitive coupling between metal plates on the outside of the sensor and ground. See U.S. Patent No. 4,689,752. Under normal conditions, accurate voltage measurements are possible. However, the accumulation of rain, snow, and/or ice on the sensor can change the capacitive coupling between the sensor and ground resulting in errors in the measurement of line voltage.

US Patent No. 4,795,973 describes a modification to a sensor with the objective of being less sensitive to snow. The entire sensor body is turned into a single, large voltage sensing plate. Such an approach may still be somewhat sensitive to snow because significant snow build-up will change the effective surface area of the sensor.

To be completely resistant to the effects of snow and ice, one typical solution is to use relatively large and heavy instrumentation transformers wired directly to each phase. A "Potential Transformer" (PT) is used to transform the line voltage down to a lower voltage that is more easily measured, typically about 120Vrms. By measuring this lower voltage and multiplying by the turns ratio of the PT, the line-to-neutral voltage of a phase can be deduced. A "Current Transformer" (CT) is used to measure current. The line to be monitored passes once through a transformer core. A secondary with many turns is also wound around the transformer core, and the secondary is either shorted or drives a very small resistance. The secondary is isolated from the voltage on the primary, and the current on the secondary is much lower than (and proportional to) the current on the line, with the turns ratio of the transformer again being the proportionality constant. Voltage, current, power, etc., are then measured by a commercial meter attached to the PT and CT (for example, the ITRON Quantum Q1000).

Such a solution, however, can be expensive and labor intensive to install.

U.S. Patent No. 6,667,743 teaches a high voltage powerline sensor with a plurality of voltage sensing devices. JP2004257893 teaches a voltage sensor for detecting voltages of overhead wires. U.S. Patent Application Publication No. US 2014/049275 A1 teaches a compensating circuit having programmable capacitance array for measuring AC voltage.

SUMMARY OF THE INVENTION

An ungrounded power line sensor measures the voltage of a medium-voltage power line relative to ground through a capacitive coupling between electrically conductive plates on the outside of the sensor and ground. Under normal conditions, accurate voltage measurements are possible. However, the presence of raindrops sitting on the surface of the sensor can change the capacitive coupling between the sensor and ground resulting in measurement errors in the line voltage. If two sets of voltage sensing plates are employed, one on top of the sensor and one on the bottom of the sensor, we discovered that the top plates tend to exhibit an increase in voltage in the presence of rain whereas the bottom plates tend to experience a decrease in voltage in the rain. By separately measuring the top and bottom plates, the presence of rain can be detected by the difference in the readings of the top and bottom plates. The deviation in sensor readings due to the rain can also be mitigated by computing a weighted average of the top and bottom sensor plate readings to yield a combined voltage reading that is insensitive to rain.

Featured is an ungrounded power line sensor system comprising a housing configured for coupling about a power line, at least a first voltage sensing plate supported by the housing and exposed to rain and snow, and at least a second voltage sensing plate supported by the housing and shielded from rain and snow. A processing subsystem is configured to (e.g., runs computer instructions which) measure a voltage sensed by the first voltage sensing plate, separately measure a voltage sensed by the second voltage sensing plate, and mitigate variations in said measurements due to a weather event by, for example, applying a weighted average calculation to the voltage measurements to cancel out the effects of rain on the first voltage sensing plate.

In one example, the measured voltage sensed by the first voltage sensing plate is $V_{top}$, the measured voltage sensed by the second voltage sensing plate is $V_{bottom}$, and the weighted average calculation is $V_{avg} = (1-c) V_{top} + c V_{bot}$ where c is a constant weighting factor.

The system may further include a current sensor and then the processing subsystem preferably measures power and energy using a current measurement output by the current sensor and a measured voltage sensed only by the second voltage sensing plate. The purpose of computing power and energy using only the bottom plate is that it has been observed that voltage measurements from the top plates can be erroneously shifted in phase during snow conditions, whereas the bottom plates (which do not accumulate snow) have little or no phase shift due to snow. In some embodiments, the processing subsystem is configured to apply a scaling factor to the power and energy measurements. The scaling factor may be a function of the measured voltage sensed by the first voltage sensing plate and the measured voltage sensed by the second voltage sensing plate. In one example, the measured voltage sensed by the first voltage sensing plate is $V_{top}$, the measured voltage sensing by the second voltage sensing plate is $V_{bot}$, and the scaling factor is (1-c) $V_{top}$ + c $V_{bot}$ divided by $V_{bot}$ where c is a constant weighting factor.

The processing subsystem may also mitigate variations in the voltage measurements by comparing the measured voltage sensed by the first voltage sensing plate and the measured voltage sensed by the second voltage sensing plate. The processing subsystem can be configured to report a snow event when the measured voltage sensed by the first voltage sensing plate differs from the measured voltage sensed by the second voltage sensing plate by a predetermined value.

In one version there is a set of electrically connected voltage sensing plates exposed to rain and snow and a set of electrically connected voltage sensing plates shielded from rain and snow. The system housing may have an apex between opposing outwardly sloping top voltage sensing plates exposed to rain and snow and opposing inwardly sloping bottom voltage sensing plates shielded from rain and snow. In some embodiments, the processing subsystem includes a first processor in the housing electrically connected to the first voltage sensing plate and separately electrically connected to the second voltage sensing plate. The system collector may also include a second processor in the collector. Thus, the processing subsystem can reside in the sensor, the collector, or can be distributed between those two components.

Also featured is an ungrounded power line sensing method comprising measuring a voltage sensed by a first voltage sensing plate located proximate a power line and exposed to rain and snow, separately measuring the voltage sensed by a second voltage sensing plate located proximate a power line but shielded from rain and snow, and mitigating variations in the voltage measurements due to a weather event.

In one embodiment, an ungrounded power line sensor system includes a housing configured for disposal about a power line, a current sensor associated with the housing for measuring power line current, a first voltage sensing plate supported by the housing and exposed to rain and snow, and a second voltage sensing plate supported by the housing and shielded from rain and snow. A processing subsystem is configured to measure a voltage sensed by the first voltage sensing plate, measure a voltage sensed by the second voltage sensing plate, mitigate variations in said measurements by applying a weighted average calculation to the voltage measurements to cancel out the effects of rain on the first voltage sensing plate, and measure power and energy using the power line current measurement and only the measured voltage sensed by the second voltage sensing plate.

An ungrounded power line sensing method includes measuring a voltage sensed by a first voltage sensing plate proximate a power line and exposed to rain and snow, measuring a voltage sensed by a second voltage sensing plate proximate a power line and shielded from rain and snow, measuring power line current, applying a weighted average calculation to said voltage measurements to cancel out the effects of rain on the first voltage sensing plate, and measuring power and energy using the measured current and only the measured voltage sensed by the second voltage sensing plate.

BRIEF DESCRIPTION OF THE SEVERAL VIEWS OF THE DRAWINGS

Other objects, features and advantages will occur to those skilled in the art from the following description of a preferred embodiment and the accompanying drawings, in which:

Fig. 1 is a schematic view showing three sensors deployed on a power line in accordance with an example of the invention;
Fig. 2 is a schematic three dimensional view of a prior art sensor;
Fig. 3 is a graph showing voltage versus time and how the prior art sensor of Fig. 2 voltage output varies from the true power line voltage during a rain event;
Fig. 4 is a schematic three dimensional view showing a new sensor in accordance with an example of the subject invention;
Fig. 5 is a schematic cross sectional view of the sensor shown in Fig. 4;
Fig. 6 is a block diagram showing the primary components associated with the sensor of Figs. 4-6;
Fig. 7 is a block diagram showing the primary components associated with a sensor subsystem wirelessly communicating with a collector powered by a single phase transformer in accordance with aspects of the invention;
Fig. 8 is a block diagram showing the primary components associated with the collector of Fig. 7;
Fig. 9 is a graph showing the voltage measured by the sensor subsystem of the subject invention compared to the actual voltage and the voltage measured by a prior art sensor during a rain event; and
Fig. 10 is a graph showing the power error over time reported by a sensor processing subsystem configured in accordance with the invention.

DETAILED DESCRIPTION OF THE INVENTION

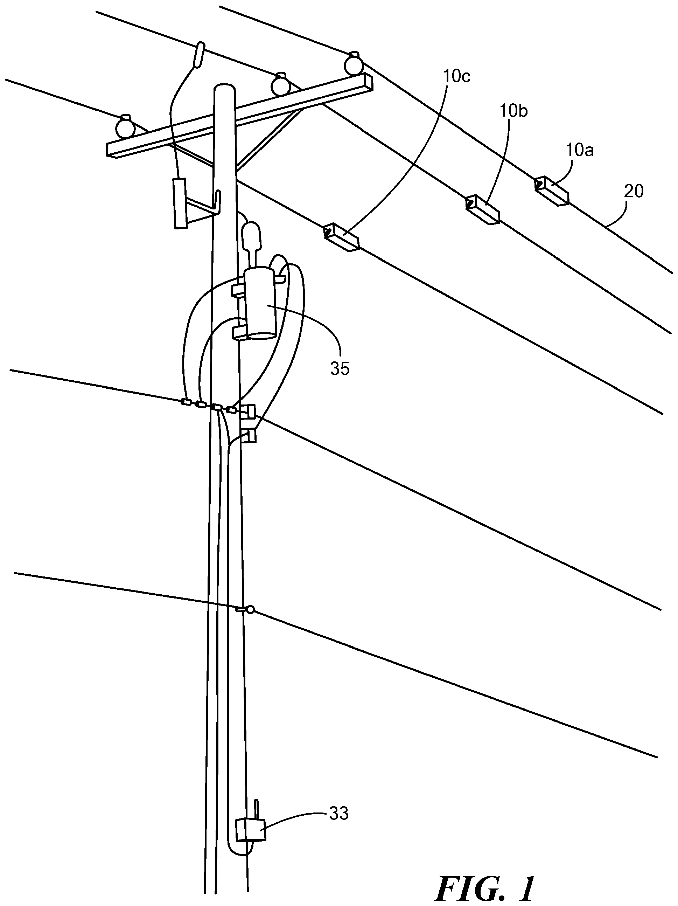

In Fig. 1, three sensors 10a, 10b, and 10c are mounted on a medium voltage three-phase power distribution feeder, one sensor on each phase of the feeder. Under normal conditions, sensors 10a, 10b, and 10c can measure voltage accurately to +/-0.5% so long as the sensor is calibrated in place after installation. The sensors communicate via radio to a collector 12 located on a nearby utility pole. A single-phase transformer 35 is attached between Phase "B" of the feeder and the neutral line. The transformer supplies the 120V power needed to power collector 33.

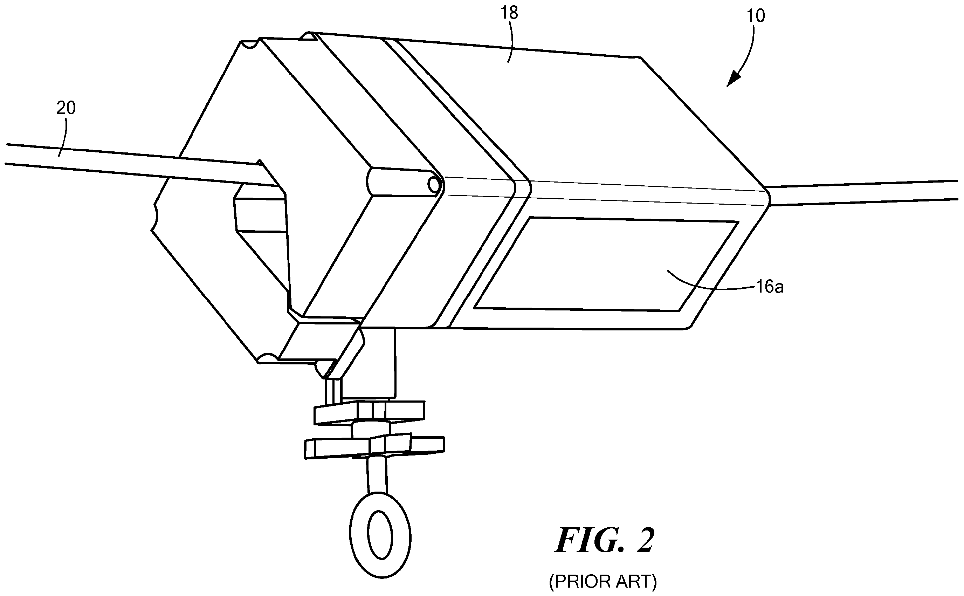

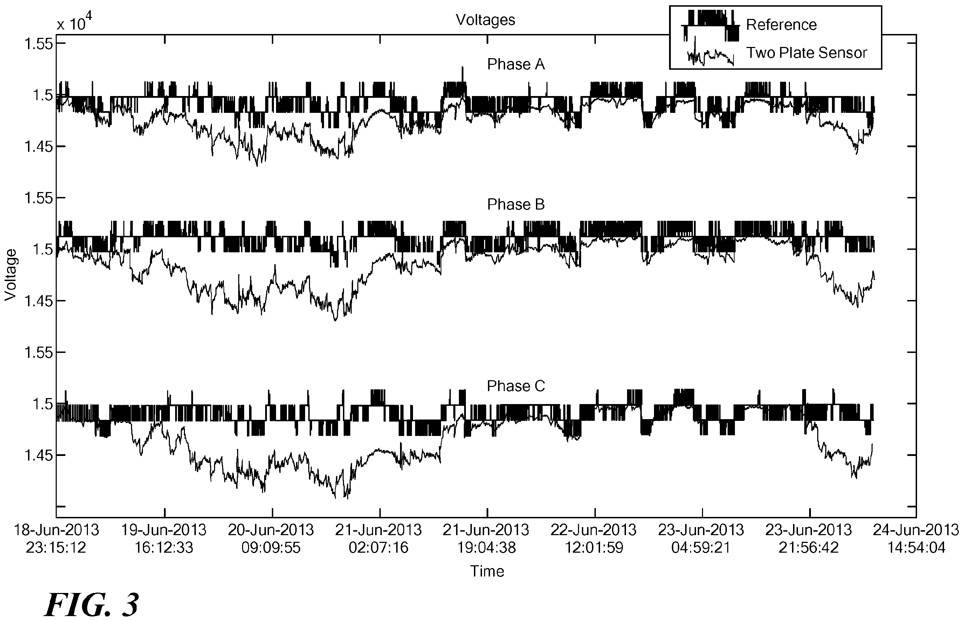

Shown in Fig. 2 is a prior art sensor 10 with housing 18 configured for disposal about power line 20. The housing supports voltage sensing plate 16a shielded from rain and snow. Fig. 3 shows the output of the phase A, phase B, and phase C sensors of the Fig. 2 design compared to a reference measuring the actual voltage in each phase. As shown in Fig. 3, the prior art sensor voltage measurements are fairly inaccurate in rain.

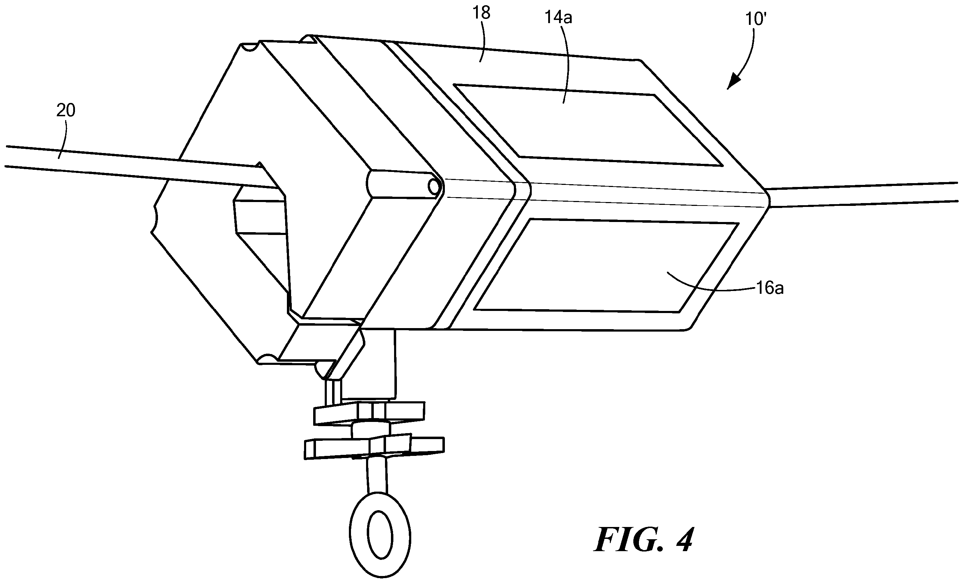

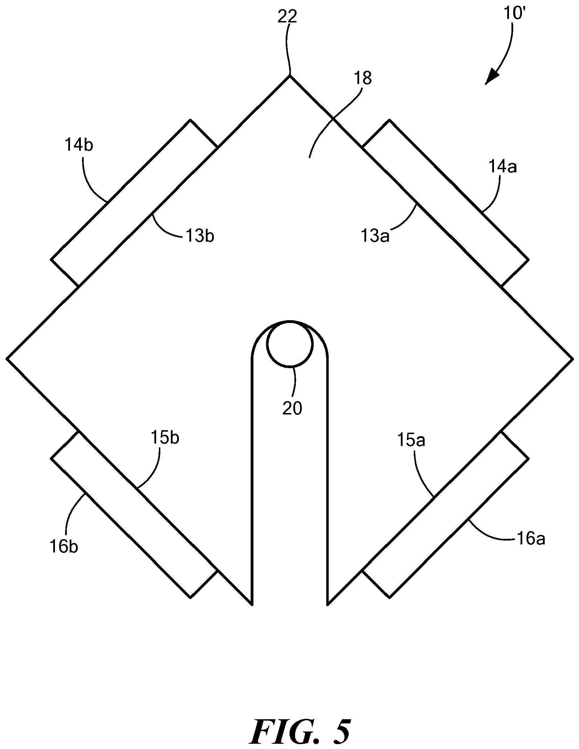

Shown in Fig. 4 is a new sensor 10' with housing 18 configured for disposal about power line 20. The housing supports first voltage sensing plate 14a exposed to rain and snow and second voltage sensing plate 16a shielded from rain and snow. In this particular example, housing 18 is a polyhedron with apex 22, Fig. 5, downwardly and outwardly sloping opposing sides 13a and 13b supporting a set of top voltage sensing plates 14a and 14b and downwardly and inwardly sloping sides 15a and 15b supporting a set of bottom voltage sensing plates 16a and 16b. The two top plates 14a and 14b may be electrically interconnected and the two bottom plates 16a and 16b may be electrically interconnected. In other versions, there is only one top plate and one bottom plate. And, other housing configurations are possible.

One discovery by the inventors hereof is that during a rain event the voltage measured by the top voltage sensing plate set (14a, 14b) increases and the voltage measured by the bottom sensing plate set decreases, even though the actual voltage of the line is unchanged. The top voltage sensing plate set (14a, 14b) experiences an increase in capacitance between the sensor plates and ground due to the rain droplets adding surface area to the top voltage sensing plate set (16a, 16b). This increase in capacitance causes the voltage measured by the top plates to increase. Even though there is no direct contact of rain with the lower voltage plates, the increased surface area of the top voltage plates and top sensor body due to rain causes charges to be preferentially distributed on the upper part of the sensor, ultimately reducing the voltage measured by the bottom voltage sensing plate set.

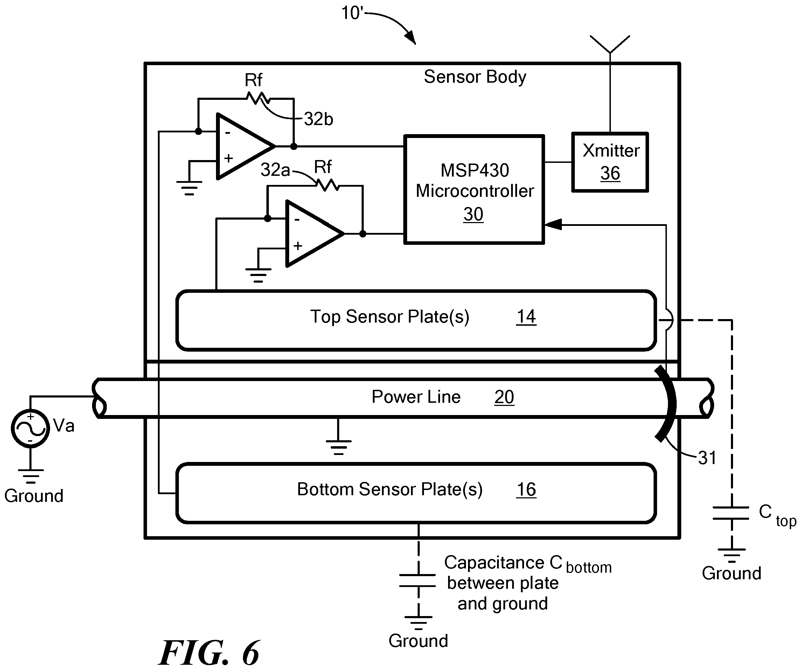

In the subject invention, microcontroller 30, Fig. 6 is separately connected electrically to the top voltage sensing plate 14 and the bottom voltage sensing plate 16 via conditioning circuitry as shown at 32a and 32b.

There is capacitive impedance between the sensor plates and ground, represented in Fig. 6 by capacitances Ctop and Cbot. The value of each capacitance is typically on the order of 1 picofarad. Controller 30 is used to measure the very small current that flows back and forth from the power line to the surface of each set of plates due to these capacitances. These currents are measures of the voltage between the power line and ground.

Internal to the sensor, separate sensing circuits are used to condition voltage measurements from the top and bottom plates as shown in Fig. 6. Both top and bottom plate channels are sampled synchronously by microcontroller 30.

On sensor install, the relationship between the voltage measured by the sensor circuit and the line-to-neutral voltage must be calibrated. The sensor system automatically and separately calibrates the readings from the top and bottom voltage sensor plates 14, 16.

Internal to the microcontroller, the RMS voltage of the top plate 14 is calculated (denoted $V_{top}$). The RMS voltage of the bottom plate 16 is also calculated ($V_{bottom}$) along with real and reactive power and energy which are a combination of voltage and current measurements. The power and energy quantities are preferably calculated only using the bottom voltage sensor plate 16 for the voltage input to the microcontroller because the bottom sensor plate, shielded by the sensor body, experiences little or no phase shift in snow conditions.

Microcontroller 30 is thus configured to measure the voltage $V_{top}$ sensed by the top voltage sensing plate(s) 14 and to separately measure the voltage $V_{bottom}$ sensed by the bottom voltage sensing plate(s) 16 and to mitigate variations between $V_{top}$ and $V_{bottom}$.

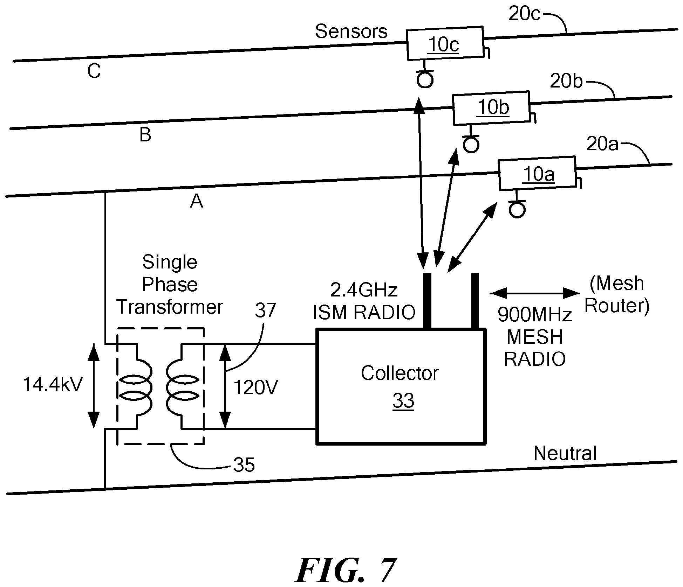

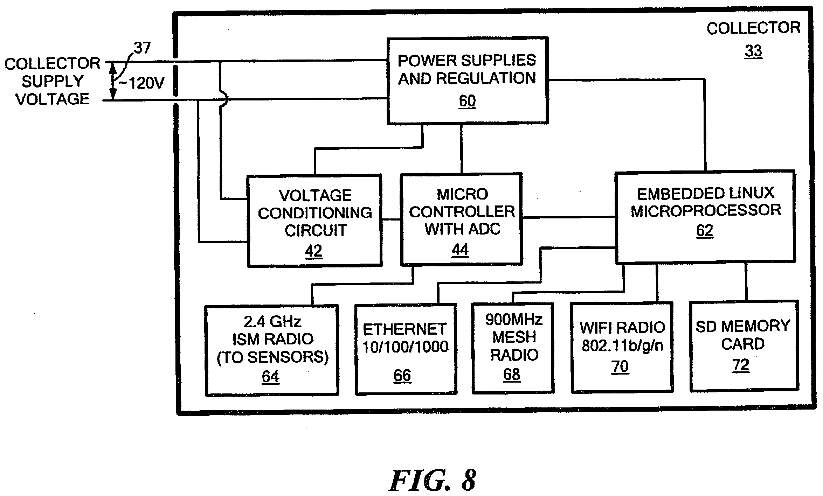

Preferably, when $V_{top}$ differs from $V_{bottom}$ by a predetermined amount (e.g., a-1% to +4% difference between top and bottom plate voltages), microcontroller 30 outputs a signal transmitted wirelessly by sensor transmitter 36 to radio 64 of collector 33, Figs. 7-8. Collector processor 62 (or microcontroller 44) is then configured to process this signal and log a rain event or, alternatively, to correct and adjust the voltage measurements as discussed below. In some examples, the processing subsystem functionality described herein is carried out by the microcontroller 30, Fig. 6 of the sensor and/or the microcontroller or microprocessor (44, 62, Fig. 8) of the collector. Various processing hardware may be used including applications specific integrated circuits, field programmable gate arrays, and the like programmed to carry out stored or uploaded computer instructions as explained herein.

The sensor 10', Fig. 6 may further include a current sensor 31 such as a Rogowski coil disposed about the power line 20 providing an output to microcontroller 30 for measuring the current of the power line 20 and transmitting the current measurement via transmitter 36 to the radio 64 of collector 33, Figs. 7-8.

Collector 33 is preferably powered from transformer 35, Fig. 7 preferably connected to ground 19 and one phase 20a of the feeder being monitored by a feeder meter sensor 10a. The single-phase transformer 35 used to power collector 33 reduces the medium voltage of the distribution line to a tractable voltage near 120Vrms. The supply voltage to collector 33 is related to the feeder 20a voltage by the transformer 35 ratio of the transformer supplying the collector.

The collector supply voltage 37 is fed into a voltage conditioning circuit 42. This circuit preferably including a voltage divider and an op amp buffer reduces the voltage from the ~120V supply voltage to a low voltage in the range of a few volts for measurement with an Analog-to-Digital Converter (ADC). In the initial reduction to practice, a circuit based on the LTC1992 differential Op Amp was employed. The signal output by the circuit 42 is then repeatedly measured by an ADC built into microcontroller chip 44 of the collector. In the one prototype device, a TI MSP-430 class microcontroller samples an associated 16-bit ADC at a rate of 2048Hz. A True RMS-type filter (in the prototype implementation, taking the RMS by squaring the sensed signal, applying a low-pass, and taking the square-root of the result) is then applied in software operated on the microcontroller 44.

The microcontroller 44 also communicates with the sensors via a 2.4GHz Industrial, Scientific, and Medical (ISM) band radio module 64 obtaining measurements of voltage, current, power, and energy from the sensors. The microcontroller 44 passes both sensor and the collector supply voltage measurement to microprocessor 62 running embedded Linux. Software on the microprocessor 62 applies scaling factors determined during calibration to the phase voltage measurement from the sensors. Collector calibration factors, also determined during calibration, may be applied to the collector supply voltage measurement to produce an alternative voltage for each phase. The software may then compare the alternative and phase voltages to determine if there is a snow condition and logs and/or corrects various measurements for the snow condition. The microprocessor 62 may use a Secure Digital (SD) Memory Card 72 to locally store the collected data may use an Ethernet module 66, a 900MHz mesh radio 68, or a WiFi Radio 70 to transmit the collected data to end consumers of the data (e.g. SCADA systems). The voltage measurement circuit configured to measure the collector's supply voltage, however, could be implemented in other ways. Only one preferred embodiment includes voltage conditioning circuit 42, microcontroller 44, and microprocessor 62.

In addition to simply detecting the presence of rain, the sensor system can correct for the presence of rain. Once per minute, a snapshot of all of a sensor's registers (i.e. voltages, current, power, energy, etc.) is taken and sent to the collector. At that time, the deviation in sensor readings due to the rain can also be mitigated by computing and reporting a weighted average of the top and bottom voltage sensor plate(s) readings to yield a combined voltage reading that is insensitive to rain. The weighted average is thus:

$$\mathrm{Vavg} = (1\text{-}c)\mathrm{Vtop} + c\mathrm{Vbot}; \qquad\qquad (1)$$

where c is a constant weighting factor that is selected based on experimental measurement of the sensor's performance in the rain. Collector 33 radio 70 transmits this computation to end users.

Power and energy values, which are computed using exclusively voltage measurements from the bottom plate, can then be adjusted by multiplying by a scaling factor.

For example, the measured real power is the instantaneous voltage multiplied by the instantaneous current. Here, the instantaneous voltage is the voltage measured only by bottom sensor plate 16, Fig. 5 and the instantaneous current is the current measured by current sensor 31. Then, the processing subsystem is configured to report a real power value which is the measured real power multiplied by a scaling factor which may be

$$V_{\mathrm{avg}}/V_{\mathrm{bot}}. \qquad\qquad (2)$$

Measured reactive power, incremental volt-hours, incremental real energy, and incremental reactive energy and the like are similarly adjusted by the same scaling factor. Since the power and energy measurements were computed using exclusively the bottom plate, the power factor and therefore the power and energy computations will be accurate in snow conditions where snow effects are corrected as described in U.S. Patent Application No. 14/621,696. The adjustment by the weighted average voltage yields robustness to the influence of rain as well.

Note that the computation of $V_{\mathrm{avg}}$ and the associated scaling operation could be performed either in the sensor prior to sending measurements to the collector or the computation could be performed in the collector itself. In the presently implemented version, the computation of $V_{\mathrm{avg}}$ and the adjustment of power and energy values takes place in the sensor.

Also note that the scaling factor could be computed using either the instantaneous top and bottom voltages at the time at which a snapshot is taken or by using the average voltage over the entire, nominally one-minute, reporting period. Initial implementations used the instantaneous voltages to perform the adjustment. Later implementations use the average top and bottom voltage over the reporting period to provide greater robustness to special situations e.g. where the rain begins part way through the reporting period.

Although a simple linear combination of $V_{top}$ and $V_{bot}$ was used in the initial implementation, other more elaborate combinations of $V_{top}$ and $V_{bot}$ might be used in the future, on the basis of future field testing and experimental results. For example, some nonlinear blend of the two voltages may yield improved performance. Alternately, the combination of plates could be the result of a real time adaptive and dynamic ratio that results from analysis of top and bottom plate voltages and predictive modeling, *i.e.* incorporating information from previous values of $V_{top}$ and $V_{bot}$ to yield more accurate adjusted values.

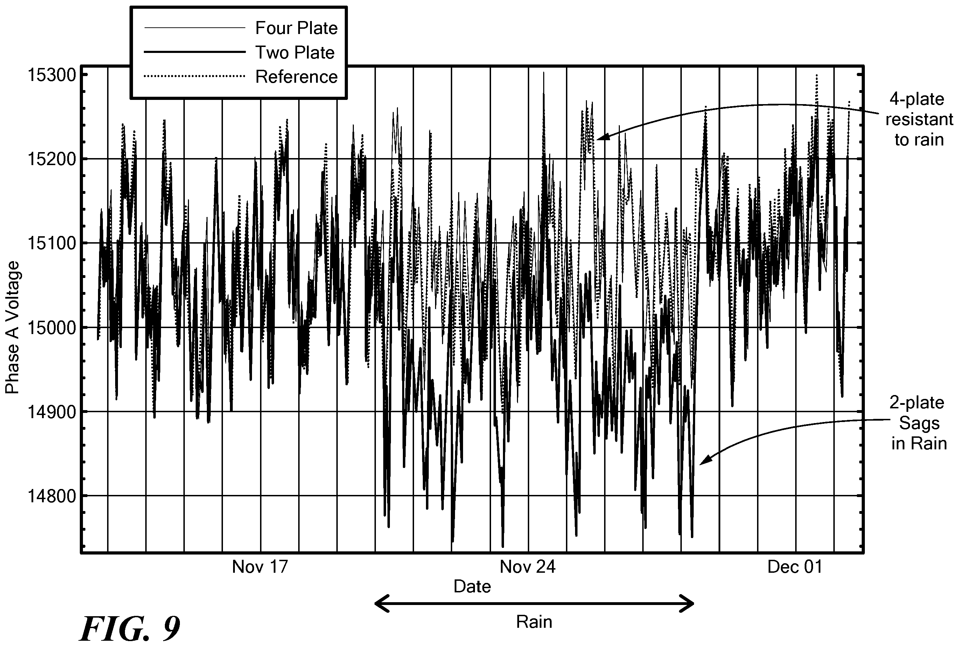

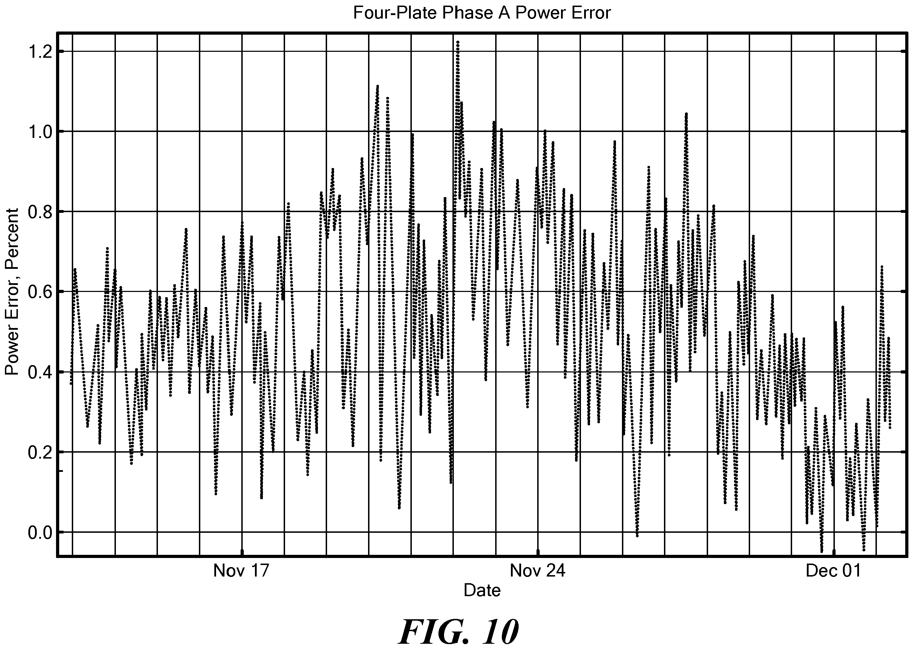

In practice, the weighted average scheme provides acceptable rain accuracy. For example, a pilot test site in Mission, BC measured the voltages as pictured in Fig. 9 at a site at which both older two-plate and newer four-plate/two-channel sensors were monitoring the same medium voltage line. As shown in Fig. 10, the power error is also acceptable.

The separate sensing of top and bottom sensors allows partial mitigation of snow effects in instances where other adjustments are not applicable (i.e. when there is no direct access to supply voltage or in cases where the supply voltage has no correlation to the voltage of the medium voltage line). When snow conditions occur, the difference in voltage between the top and bottom plates exceeds the difference that is normally expected during rainy conditions.

If the discrepancy between top and bottom plates is large enough to indicate snow conditions, the sensors can then communicate this condition to external equipment that is monitoring the sensor's measurements. For example, the sensors might communicate this information digitally, e.g. via a field in the sensor's DNP3 messaging interface. A more elaborate implementation of snow reporting could incorporate the temperature reading of the sensor and use additional logic to infer actionable weather information which would then be transmitted back to the utility, *e.g.* indicating the presence of potentially damaging freezing rain conditions versus more benign snowfall, etc.

An indication of a snow condition can also be conveyed in an analog form. For one of implementations, the sensor is used as a voltage input to a capacitor bank controller. The collector communicates with the capacitor bank controller by producing an AC analog output voltage proportional to the voltage measured by the line-mounted sensor. The capacitor bank controller then measures the analog signal from the collector as an indication of the line voltage (i.e. as if the sensor were an electronic voltage transformer). If snow conditions are detected by the system, the collector generates a low voltage, specifically chosen to be below the capacitor bank controller's "inhibit voltage", the voltage below which capacitor switching functionality is disabled by the capacitor bank controller. In this way, the capacitor bank controller will not switch during a snow event.

The strategy for identifying and indicating snow conditions in the capacitor bank sensor scenario can be outlined as follows:

1) The sensor measure RMS voltage for both top and bottom sensing plates and sends them to the collector;
2) The sensor computes real and reactive power based on the top voltage and current (real and reactive power are used to determine in-phase and out-of-phase portions of the current).
3) The top and bottom plates are separately calibrated during install;
4) The collector has adjustable upper and lower error limits for top and bottom plates, nominally set at -1 %/+4%;
5) During operation, enter Voltage Error Mode if set voltage equal to the predefined Error Voltage if % Error is out of bounds.
6) During Voltage Error Mode, collector outputs a low-amplitude AC voltage of prescribed amplitude to the capacitor bank controller instead of producing an AC voltage proportional to the RMS voltage measured by the sensor.
7) Otherwise, operate normally.

Although specific features of the invention are shown in some drawings and not in others, this is for convenience only as each feature may be combined with any or all of the other features in accordance with the invention. The words "including", "comprising", "having", and "with" as used herein are to be interpreted broadly and comprehensively and are not limited to any physical interconnection. Moreover, any embodiments disclosed in the subject application are not to be taken as the only possible embodiments.

Other embodiments will occur to those skilled in the art and are within the following claims.

**Claims**

1.  An ungrounded power line sensor system comprising:

    a housing (18) configured for coupling about a power line (20);
    at least a first voltage sensing plate (14a) supported by the housing (18) and exposed to rain and snow;
    at least a second voltage sensing plate (16a) supported by the housing (18) and shielded from rain and snow;
    the system **characterized by**:
    a processing subsystem (30,44,62) configured to:

measure a voltage sensed by the first voltage sensing plate (14a),
separately measure a voltage sensed by the second voltage sensing plate (16a), and
mitigate variations in said measurements due to a weather event.

2. The system of claim 1 in which the processing subsystem (30,44,62) is configured to mitigate variations in said measurements by applying a weighted average calculation to said measurements to cancel out the effects of rain on the first voltage sensing plate (14a).

3. The system of claim 2 in which the measured voltage sensed by the first voltage sensing plate (14a) is $V_{top}$, the measured voltage sensed by the second voltage sensing plate (16a) is $V_{bot}$, and the weighted average calculation is $V_{avg} = (1\text{-}c)\, V_{top} + c\, V_{bot}$ where c is a constant weighting factor.

4. The system of claim 1 further including a current sensor (31) and wherein the processing subsystem (30,44,62) is further configured to measure power and energy using a current measurement output by the current sensor (31) and a measured voltage sensed only by the second voltage sensing plate (16a).

5. The system of claim 4 in which the processing subsystem (30,44,62) is configured to apply a scaling factor to said power and energy measurements, in which said scaling factor is a function of the measured voltage sensed by the first voltage sensing plate (14a) and the measured voltage sensed by the second voltage sensing plate (16a).

6. The system of claim 5 in which the measured voltage sensed by the first voltage sensing plate (14a) is $V_{top}$, the measured voltage sensed by the second voltage sensing plate (16a) is $V_{bot}$ and the scaling factor is $(1\text{-}c)\, V_{top} + c\, V_{bot}$ divided by $V_{bot}$ where c is a constant weighting factor.

7. The system of claim 1 in which the processing subsystem is further configured to report a snow event when the measured voltage sensed by the first voltage sensing plate (14a) differs from the measured voltage sensed by the second voltage sensing plate (16a) by a predetermined value.

8. The system of claim 1 in which there are two electrically connected voltage sensing plates (14a, 14b) exposed to rain and snow and two electrically connected voltage sensing plates (16a, 16b) shielded from rain and snow, in which the housing has an apex (22) between opposing outwardly sloping top voltage sensing plates (14a, 14b) exposed to rain and snow and opposing inwardly sloping bottom voltage sensing plates (16a, 16b) shielded from rain and snow.

9. An ungrounded power line sensing method comprising:

measuring a voltage sensed by a first voltage sensing plate (14a) proximate a power line (20) and exposed to rain and snow;
separately measuring the voltage sensed by a second voltage sensing plate (16a) proximate the power line (20) and shielded from rain and snow; and
mitigating variations in said measurements due to a weather event.

10. The method of claim 9 in which mitigating variations in said measurements includes applying a weighted average calculation to said measurements to cancel out effects of rain on the first voltage sensing plate (14a).

11. The method of claim 10 in which the measured voltage sensed by the first voltage sensing plate (14a) is $V_{top}$, the measured voltage sensed by the second voltage sensing plate (16a) is $V_{bot}$, and the weighted average calculation is $V_{avg} = (1\text{-}c)\, V_{top} + c\, V_{bot}$ where c is a constant weighting factor.

12. The method of claim 9 further including measuring power line current and measuring power and energy using a current measurement and a measured voltage sensed only by the second voltage sensing plate (16a).

13. The method of claim 12 further including applying a scaling factor to said power and energy measurements, in which said scaling factor is a function of the measured voltage sensed by the first voltage sensing plate (14a) and the measured voltage sensed by the second voltage sensing plate (16a).

14. The method of claim 13 in which the measured voltage sensed by the first voltage sensing plate (14a) is $V_{top}$, the measured voltage sensing by the second voltage sensing plate (16a) is $V_{bot}$, and the scaling factor is $(1\text{-}c)\, V_{top} +$

c $V_{bot}$ divided by $V_{bot}$ where c is a constant weighting factor.

**15.** The method of claim 9 further including reporting a snow event when the measured voltage sensed by the first voltage sensing plate (14a) differs from the measured voltage sensed by the second voltage sensing plate (16a) by a predetermined value.

**16.** The system of claim 1 in which the processing subsystem (30,44,62) is configured to calculate and report a power line voltage as a function of the voltage sensed by the first voltage sensing plate (14a) and the voltage sensed by the second voltage sensing plate (16a).

**17.** The system of claim 1 in which the processing subsystem (30,44,62) is configured to detect when a voltage sensed by the first voltage sensing plate (14a) differs from a voltage sensed by the second voltage sensing plate (16a) by a predetermined amount due to rain or snow on the first voltage sensing plate (14a).

**18.** The system of claim 17 in which the processing subsystem (30,44,62) is configured to log an event.

**19.** The system of claim 3 in which the constant weighting factor c is determined by first and second voltages sensed when the first voltage sensing plate (14a) is in the presence of rain or snow and the second voltage sensing plate (16a) is not in the presence of rain or snow.

**20.** The system of claim 1 in which the processing subsystem (30,44,62) includes a first processor (30) in the housing (18) electrically connected to the first voltage sensing plate (14a) and separately connected to the second voltage sensing plate (16a), and the system further including a collector (33) and the processing subsystem includes a second processor (44, 62) in the collector (33).

**21.** The method of claim 9 further including detecting when the first voltage differs from the second voltage by a predetermined amount due to rain or snow on the first voltage sensing plate (14a) and, in response, logging an event.

**Patentansprüche**

**1.** Ungeerdetes Stromleitungssensorsystem, das Folgendes umfasst:

ein Gehäuse (18), das konfiguriert ist, über eine Stromleitung (20) zu koppeln;
mindestens eine erste Spannungserfassungsplatte (14a), die durch das Gehäuse (18) getragen wird und Regen und Schnee ausgesetzt ist;
mindestens eine zweite Spannungserfassungsplatte (16a), die durch das Gehäuse (18) getragen wird und von Regen und Schnee abgeschirmt ist; wobei das System **gekennzeichnet ist durch**:
ein Verarbeitungsuntersystem (30, 44, 62), das konfiguriert ist zum:

Messen einer **durch** die erste Spannungserfassungsplatte (14a) erfassten Spannung;
getrennten Messen einer **durch** die zweite Spannungserfassungsplatte (16a) erfassten Spannung und Abschwächen von Variationen in den Messungen aufgrund eines Wetterereignisses.

**2.** System nach Anspruch 1, wobei das Verarbeitungsuntersystem (30, 44, 62) konfiguriert ist, Variationen in den Messungen durch Anwenden einer gewichteten Mittelwertberechnung auf die Messungen, um die Auswirkungen von Regen auf die erste Spannungserfassungsplatte (14a) aufzuheben, abzuschwächen.

**3.** System nach Anspruch 2, wobei die durch die erste Spannungserfassungsplatte (14a) erfasste gemessene Spannung $V_{top}$ ist, die durch die zweite Spannungserfassungsplatte (16a) erfasste gemessene Spannung $V_{bot}$ ist und die gewichtete Mittelwertberechnung $V_{avg} = (1-c) V_{top} + c V_{bot}$ ist, wobei c ein konstanter Gewichtungsfaktor ist.

**4.** System nach Anspruch 1, das ferner einen Stromsensor (31) enthält und wobei das Verarbeitungsuntersystem (30, 44, 62) ferner konfiguriert ist, Leistung und Energie unter Verwendung einer Strommessung, die durch den Stromsensor (31) ausgegeben wird, und einer gemessenen Spannung, die nur durch die zweite Spannungserfassungsplatte (16a) erfasst wird, zu messen.

**5.** System nach Anspruch 4, wobei das Verarbeitungsuntersystem (30, 44, 62) konfiguriert ist, einen Skalierungsfaktor auf die Leistungs- und Energiemessungen anzuwenden, wobei der Skalierungsfaktor eine Funktion der durch die erste Spannungserfassungsplatte (14a) erfassten gemessenen Spannung und der durch die zweite Spannungserfassungsplatte (16a) erfassten gemessenen Spannung ist.

6. System nach Anspruch 5, wobei die durch die erste Spannungserfassungsplatte (14a) erfasste gemessene Spannung $V_{top}$ ist, die durch die zweite Spannungserfassungsplatte (16a) erfasste gemessene Spannung $V_{bot}$ ist und der Skalierungsfaktor $(1-c) V_{top} + c V_{bot}$ geteilt durch $V_{bot}$ ist, wobei c ein konstanter Gewichtungsfaktor ist.

7. System nach Anspruch 1, wobei das Verarbeitungsuntersystem ferner konfiguriert ist, ein Schneeereignis zu melden, wenn die durch die erste Spannungserfassungsplatte (14a) erfasste gemessene Spannung von der durch die zweite Spannungserfassungsplatte (16a) erfassten gemessenen Spannung um einen vorbestimmten Wert verschieden ist.

8. System nach Anspruch 1, wobei es zwei elektrisch verbundene Spannungserfassungsplatten (14a, 14b), die Regen und Schnee ausgesetzt sind, und zwei elektrisch verbundene Spannungserfassungsplatten (16a, 16b), die von Regen und Schnee abgeschirmt sind, gibt, wobei das Gehäuse einen Höhepunkt (22) zwischen gegenüberliegenden nach außen geneigten oberen Spannungserfassungsplatten (14a, 14b), die Regen und Schnee ausgesetzt sind, und gegenüberliegenden nach innen geneigten unteren Spannungserfassungsplatten (16a, 16b), die von Regen und Schnee abgeschirmt sind, besitzt.

9. Ungeerdetes Stromleitungserfassungsverfahren, das Folgendes umfasst:

   Messen einer durch eine erste Spannungserfassungsplatte (14a), die sich in der Nähe einer Stromleitung (20) befindet und Regen und Schnee ausgesetzt ist, erfassten Spannung;
   getrenntes Messen der durch eine zweite Spannungserfassungsplatte (16a), die sich in der Nähe der Stromleitung (20) befindet und von Regen und Schnee abgeschirmt ist, erfassten Spannung; und
   Abschwächen von Variationen in den Messungen aufgrund eines Wetterereignisses.

10. Verfahren nach Anspruch 9, wobei das Abschwächen von Variationen in den Messungen enthält, eine gewichtete Mittelwertberechnung auf die Messungen anzuwenden, um Auswirkungen von Regen auf die erste Spannungserfassungsplatte (14a) aufzuheben.

11. Verfahren nach Anspruch 10, wobei die durch die erste Spannungserfassungsplatte (14a) erfasste gemessene Spannung $V_{top}$ ist, die durch die zweite Spannungserfassungsplatte (16a) erfasste gemessene Spannung $V_{bot}$ ist und die gewichtete Mittelwertberechnung $V_{avg} = (1-c) V_{top} + c V_{bot}$ ist, wobei c ein konstanter Gewichtungsfaktor ist.

12. Verfahren nach Anspruch 9, das ferner enthält, einen Stromleitungsstrom zu messen und Leistung und Energie unter Verwendung einer Strommessung und einer gemessenen Spannung, die nur durch die zweite Spannungserfassungsplatte (16a) erfasst wird, zu messen.

13. Verfahren nach Anspruch 12, das ferner enthält, einen Skalierungsfaktor auf die Leistungs- und Energiemessungen anzuwenden, wobei der Skalierungsfaktor eine Funktion der durch die erste Spannungserfassungsplatte (14a) erfassten gemessenen Spannung und der durch die zweite Spannungserfassungsplatte (16a) erfassten gemessenen Spannung ist.

14. Verfahren nach Anspruch 13, wobei die durch die erste Spannungserfassungsplatte (14a) erfasste gemessene Spannung $V_{top}$ ist, die durch die zweite Spannungserfassungsplatte (16a) erfasste gemessene Spannung $V_{bot}$ ist und der Skalierungsfaktor $(1-c) V_{top} + c V_{bot}$ geteilt durch $V_{bot}$ ist, wobei c ein konstanter Gewichtungsfaktor ist.

15. Verfahren nach Anspruch 9, das ferner enthält, ein Schneeereignis zu melden, wenn die durch die erste Spannungserfassungsplatte (14a) erfasste gemessene Spannung von der durch die zweite Spannungserfassungsplatte (16a) erfassten gemessenen Spannung um einem vorbestimmten Wert verschieden ist.

16. System nach Anspruch 1, wobei das Verarbeitungsuntersystem (30, 44, 62) konfiguriert ist, eine Stromleitungsspannung als eine Funktion der durch die erste Spannungserfassungsplatte (14a) erfassten Spannung und der durch die zweite Spannungserfassungsplatte (16a) erfassten Spannung zu berechnen und zu melden.

17. System nach Anspruch 1, wobei das Verarbeitungsuntersystem (30, 44, 62) konfiguriert ist, zu detektieren, wenn eine durch die erste Spannungserfassungsplatte (14a) erfasste Spannung von einer durch die zweite Spannungserfassungsplatte (16a) erfassten Spannung aufgrund von Regen oder Schnee auf der ersten Spannungserfassungsplatte (14a) um einen vorbestimmten Betrag verschieden ist.

18. System nach Anspruch 17, wobei das Verarbeitungsuntersystem (30, 44, 62) konfiguriert ist, ein Ereignis zu protokollieren.

19. System nach Anspruch 3, wobei der konstante Gewichtungsfaktor c durch eine erste und eine zweite Spannung bestimmt wird, die erfasst werden, wenn die erste Spannungserfassungsplatte (14a) in der Gegenwart von Regen oder Schnee ist und die zweite Spannungserfassungsplatte (16a) nicht in der Gegenwart von Regen oder Schnee ist.

20. System nach Anspruch 1, wobei das Verarbeitungsuntersystem (30, 44, 62) einen ersten Prozessor (30) in dem Gehäuse (18) enthält, der mit der ersten Spannungserfassungsplatte (14a) elektrisch verbunden und getrennt mit der zweiten Spannungserfassungsplatte (16a) verbunden ist, und das System ferner einen Kollektor (33) enthält und das Verarbeitungsuntersystem einen zweiten Prozessor (44, 62) in dem Kollektor (33) enthält.

21. Verfahren nach Anspruch 9, das ferner enthält, zu detektieren, wenn die erste Spannung von der zweiten Spannung aufgrund von Regen oder Schnee auf der ersten Spannungserfassungsplatte (14a) um einen vorbestimmten Betrag verschieden ist, und als Reaktion darauf ein Ereignis zu protokollieren.

## Revendications

1. Système de capteur pour ligne d'énergie non mise à la terre, comprenant :

   un boîtier (18) configuré pour un couplage autour d'une ligne d'énergie (20) ;
   au moins un premier panneau de détection de tension (14a) porté par le boîtier (18) et exposé à la pluie et à la neige ;
   au moins un deuxième panneau de détection de tension (16a) porté par le boîtier (18) et protégé de la pluie et de la neige ;
   le système étant **caractérisé par** :
   un sous-système de traitement (30, 44, 62), configuré pour :

      mesurer une tension détectée par le premier panneau de détection de tension (14a),
      mesurer séparément une tension détectée par le deuxième panneau de détection de tension (16a), et
      atténuer des variations desdites mesures, dues à un évènement météorologique.

2. Système selon la revendication 1, dans lequel le sous-système de traitement (30, 44, 62) est configuré pour atténuer les variations desdites mesures en appliquant auxdites mesures un calcul de moyenne pondérée afin d'annuler les effets de la pluie sur le premier panneau de détection de tension (14a).

3. Système selon la revendication 2, dans lequel la tension mesurée détectée par le premier panneau de détection de tension (14a) est $V_{top}$, la tension mesurée détectée par le deuxième panneau de détection de tension (16a) est $V_{bot}$, et le calcul de moyenne pondérée est $V_{avg} = (1\text{-}c)\, V_{top} + c\, V_{bot}$, où c est un facteur de pondération constant.

4. Système selon la revendication 1, comprenant en outre un capteur de courant (31), et dans lequel le sous-système de traitement (30, 44, 62) est en outre configuré pour mesurer la puissance et l'énergie en utilisant une mesure de courant sortie par le capteur de courant (31) et une tension mesurée détectée uniquement par le deuxième panneau de détection de tension (16a).

5. Système selon la revendication 4, dans lequel le sous-système de traitement (30, 44, 62) est configuré pour appliquer un facteur d'échelle auxdites mesures de puissance et d'énergie, ledit facteur d'échelle étant une fonction de la tension mesurée détectée par le premier panneau de détection de tension (14a) et de la tension mesurée détectée par le deuxième panneau de détection de tension (16a).

6. Système selon la revendication 5, dans lequel la tension mesurée détectée par le premier panneau de détection de tension (14a) est $V_{top}$, la tension mesurée détectée par le deuxième panneau de détection de tension (16a) est $V_{bot}$ et le facteur d'échelle est $(1\text{-}c)\, V_{top} + c\, V_{bot}$, divisé par $V_{bot}$, où c est un facteur de pondération constant.

**7.** Système selon la revendication 1, dans lequel le sous-système de traitement est en outre configuré pour signaler un évènement neigeux lorsque la tension mesurée détectée par le premier panneau de détection de tension (14a) diffère de la tension mesurée détectée par le deuxième panneau de détection de tension (16a) d'une valeur prédéterminée.

**8.** Système selon la revendication 1, dans lequel il existe deux panneaux de détection de tension (14a, 14b), connectés électriquement et exposés à la pluie et à la neige, et deux panneaux de détection de tension (16a, 16b), connectés électriquement et protégés de la pluie et de la neige, dans lequel le boîtier présente un sommet (22) entre des panneaux de détection de tension supérieurs (14a, 14b), inclinés vers l'extérieur, opposés et exposés à la pluie et à la neige, et des panneaux de détection de tension inférieurs (16a, 16b), inclinés vers l'intérieur, opposés et protégés de la pluie et de la neige.

**9.** Procédé de détection pour une ligne d'énergie non mise à la terre, comprenant les étapes consistant à :

mesurer une tension détectée par un premier panneau de détection de tension (14a) à proximité d'une ligne d'énergie (20) et exposé à la pluie et à la neige ;
mesurer séparément la tension détectée par un deuxième panneau de détection de tension (16a) à proximité de la ligne d'énergie (20) et protégé de la pluie et de la neige ; et
atténuer les variations desdites mesures, dues à un évènement météorologique.

**10.** Procédé selon la revendication 9, dans lequel l'atténuation des variations desdites mesures comprend l'application d'un calcul de moyenne pondérée auxdites mesures afin d'annuler les effets de la pluie sur le premier panneau de détection de tension (14a).

**11.** Procédé selon la revendication 10, dans lequel la tension mesurée détectée par le premier panneau de détection de tension (14a) est $V_{top}$, la tension mesurée détectée par le deuxième panneau de détection de tension (16a) est $V_{bot}$, et le calcul de moyenne pondérée est $V_{avg} = (1-c) V_{top} + c V_{bot}$, où c est un facteur de pondération constant.

**12.** Procédé selon la revendication 9, comprenant en outre la mesure du courant de ligne d'énergie et la mesure de la puissance et de l'énergie en utilisant une mesure de courant et une tension mesurée détectée seulement par le deuxième panneau de détection de tension (16a).

**13.** Procédé selon la revendication 12, comprenant en outre l'application d'un facteur d'échelle auxdites mesures de puissance et d'énergie, ledit facteur d'échelle étant une fonction de la tension mesurée détectée par le premier panneau de détection de tension (14a) et de la tension mesurée détectée par le deuxième panneau de détection de tension (16a).

**14.** Procédé selon la revendication 13, dans lequel la tension mesurée détectée par le premier panneau de détection de tension (14a) est $V_{top}$, la tension mesurée détectée par le deuxième panneau de détection de tension (16a) est $V_{bot}$, et le facteur d'échelle est $(1-c) V_{top} + c V_{bot}$, divisé par $V_{bot}$, où c est un facteur de pondération constant.

**15.** Procédé selon la revendication 9, comprenant en outre la signalisation d'un évènement neigeux lorsque la tension mesurée détectée par le premier panneau de détection de tension (14a) diffère de la tension mesurée détectée par le deuxième panneau de détection de tension (16a) d'une valeur prédéterminée.

**16.** Système selon la revendication 1, dans lequel le sous-système de traitement (30, 44, 62) est configuré pour calculer et signaler une tension de ligne d'énergie comme une fonction de la tension détectée par le premier panneau de détection de tension (14a) et de la tension détectée par le deuxième panneau de détection de tension (16a).

**17.** Système selon la revendication 1, dans lequel le sous-système de traitement (30, 44, 62) est configuré pour détecter quand une tension détectée par le premier panneau de détection de tension (14a) diffère d'une tension détectée par le deuxième panneau de détection de tension (16a) d'une quantité prédéterminée en raison de la pluie ou de la neige sur le premier panneau de détection de tension (14a).

**18.** Système selon la revendication 17, dans lequel le sous-système de traitement (30, 44, 62) est configuré pour enregistrer un évènement.

**19.** Système selon la revendication 3, dans lequel le facteur de pondération constant c est déterminé par les première et deuxième tensions détectées lorsque le premier panneau de détection de tension (14a) est en présence de pluie ou de neige et le deuxième panneau de détection de tension (16a) n'est pas en présence de pluie ou de neige.

20. Système selon la revendication 1, dans lequel le sous-système de traitement (30, 44, 62) comprend un premier processeur (30) dans le boîtier (18), connecté électriquement au premier panneau de détection de tension (14a) et connecté séparément au deuxième panneau de détection de tension (16a), et le système comprenant en outre un collecteur (33) et le sous-système de traitement comprenant un deuxième processeur (44, 62) dans le collecteur (33).

21. Procédé selon la revendication 9, comprenant en outre la détection du moment où la première tension diffère de la deuxième tension d'une quantité prédéterminée en raison de la pluie ou de la neige sur le premier panneau de détection de tension (14a), et en réponse, l'enregistrement d'un évènement.

*FIG. 1*

FIG. 2
(PRIOR ART)

FIG. 3

*FIG. 4*

**FIG. 5**

FIG. 6

EP 3 311 177 B1

*FIG. 7*

*FIG. 8*

**FIG. 9**

EP 3 311 177 B1

Four-Plate Phase A Power Error

*FIG. 10*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4689752 A
- US 4795973 A
- US 6667743 B
- JP 2004257893 B
- US 2014049275 A1
- US 621696